**Europäisches Patentamt**

**European Patent Office**

**Office européen des brevets**

(19)

(11) Veröffentlichungsnummer: **0 158 216**
**B1**

(12) ## EUROPÄISCHE PATENTSCHRIFT

(45) Veröffentlichungstag der Patentschrift:
**04.01.89**

(51) Int. Cl.⁴: **H 05 K 7/18,** H 02 B 1/08,
A 47 B 91/00

(21) Anmeldenummer: **85103593.1**

(22) Anmeldetag: **26.03.85**

(54) Sockel für einen Schaltschrank.

(30) Priorität: **03.04.84 DE 3412291**

(43) Veröffentlichungstag der Anmeldung:
**16.10.85 Patentblatt 85/42**

(45) Bekanntmachung des Hinweises auf die Patenterteilung:
**04.01.89 Patentblatt 89/1**

(84) Benannte Vertragsstaaten:
**AT BE CH FR GB IT LI LU NL SE**

(56) Entgegenhaltungen:
**BE-A-851 176**
**DE-A-3 326 304**
**US-A-2 975 227**

(73) Patentinhaber: **Rittal- Werk Rudolf Loh GmbH &
Co. KG, Siegener Strasse 31, D-6341
Rittershausen (DE)**

(72) Erfinder: **Debus, Jürgen, Am Ebersbach 50, D-6344
Dietzhölztal 1 (DE)**
Erfinder: **Zachrei, Jürgen, Am Hungersberg 2,
D-6341 Dillenburg 6 (DE)**
Erfinder: **Bütergerds, Helmut, Jahnstrasse 12,
D-6345 Eschenburg 1 (DE)**

(74) Vertreter: **Vogel, Georg, Hermann- Essig- Strasse
35, D-7141 Schwieberdingen (DE)**

## Beschreibung

Die Erfindung betrifft einen Sockel für einen Schaltschrank, der aus vier Eckstücken, mindestens zwei Querblenden und mindestens zwei Längsblenden zu einem Rahmen zusammengesetzt ist, bei dem die Eckstücke zwei im rechten Winkel zueinander stehende vertikale Außenwände, sowie unten und oben horizontale, mit Schrank-Befestigungsbohrungen versehene Schrank-Befestigungsflansche aufweisen und bei dem die Querblenden und die Längsblenden so mit den Eckstücken verschraubbar sind, daß sie bündig an die Außenflächen der Eckstücke anschließen.

Ein derartiger Sockel dient dazu, den Schaltschrank höher zu stellen und einen Raum unter dem Schaltschrank zu schaffen, in dem die Verkabelung zum Schrank und von Schrank zu Schrank einer Schrankreihe untergebracht werden kann. Die Schaltschränke bestehen vielfach aus einem Rahmengestell, an dem die Schranktür angelenkt ist und das mit Wandplatten und einer Deckenplatte verkleidet wird. Die Bodenplatte ist oft unterteilt und kann leicht vom Rahmengestell gelöst werden, um die Kabel in den Schrankinnenraum einführen zu können.

Bei den bekannten Sockeln dieser Art wird das Rahmengestell des Schaltschrankes mit den Schrank-Befestigungsflanschen der Eckstücke verschraubt. Die Querblenden und die Längsblenden werden von außen her mit den Eckstücken verschraubt, die dazu gegenüber den Außenflächen um die Dicke der Blenden zurückgesetzte Befestigungsflächen tragen.

Dieser Aufbau des Sockels ist jedoch sehr nachteilig, wenn in einer Schaltschrankreihe nachträglich eine Querblende entfernt werden muß, was bei einer Nachrüstung und einem Nachziehen von Kabeln immer wieder vorkommt. Dies ist bei den bekannten Sockeln nur möglich, wenn die Schaltschrankreihe so weit verändert oder getrennt wird, daß von außen her Zugang zu der zu entfernenden Querblende besteht.

Es ist Aufgabe der Erfindung, einen Sockel für einen Schaltschrank der eingangs erwähnten Art zu schaffen, bei dem auch bei einem in einer Schaltschrankreihe angeordneten Schaltschrank die Querblenden und die Längsblenden von den Eckstücken gelöst werden können, ohne die Schaltschrankreihe verändern zu müssen.

Diese Aufgabe wird nach der Erfindung dadurch gelöst, daß die winkelförmig ausgebildeten Eckstücke an den einander abgekehrten, vertikalen Kanten der Außenwände in rechtwinklig nach innen gebogene und mit einem Raster von Blenden-Befestigungsbohrungen versehene Blenden-Befestigungsflansche übergehen und daß die Querblenden und die Längsblenden boxartig ausgebildet sind, wobei die den Blenden-Befestigungsflanschen der Eckstücke zugekehrten Querseitenwände der Querblenden und der Längsblenden mit einem entsprechenden Raster von Befestigungsbohrungen versehen sind.

Wird in dem mit dem Sockel verbundenen Schaltschrank die Bodenplatte entfernt, dann besteht bei diesem Aufbau des Sockels Zugang zu dem Innenraum des Sockels und von dort aus auch zu den Schraubverbindungen zwischen den Eckstücken und den Blenden. Auf diese Weise kann jede Blende von den zugeordneten Eckstücken gelöst und über den Innenraum des Sockels abgenommen und entfernt werden. Stehen zwei Schaltschränke mit Sockel nebeneinander, dann kann jederzeit durch Herausnehmen der beiden benachbarten Querblenden der Schaltschränke ein Übergang zwischen den Schaltschränken geschaffen werden, ohne den Aufstellungsort der Schaltschränke zu verändern. Dies erleichtert die Nachrüstung bzw. Ergänzung der Verkabelung einer Schaltschrankreihe ganz erheblich.

Ist nach einer Ausgestaltung vorgesehen, daß die Querseitenwände der Längsblenden an ihren freien Kanten nach außen gerichtete Abkantungen aufweisen, die die zugekehrten Blenden-Befestigungsflansche der Eckstücke übergreifen und die Längsblenden gegen Verdrehen sichern, dann können die Längsblenden jeweils mit einer einzigen Schraubverbindung mit den Eckstücken verdrehsicher verbunden werden.

In der einfachsten Ausgestaltung ist vorgesehen, daß vier Eckstücke, zwei Querblenden und zwei Längsblenden gleiche Höhe aufweisen und zu einem Rahmen zusammengesetzt sind. Dieser Rahmen kann die Grundhöhe eines normalen Sockels aufweisen. Zwei gleiche Rahmen lassen sich übereinander anordnen und miteinander verbinden, um einen ausreichend großen Raum unter dem Schaltschrank zur Aufnahme der Verkabelung zu erhalten.

Ist die Ausgestaltung so, daß vier Eckstücke die doppelte Höhe aufweisen wie vier Querblenden und vier Längsblenden und mit diesen zu einem Rahmen zusammengesetzt sind, dann lassen sich die Querblenden auch einzeln abnehmen, um einen Übergang zu schaffen. Die verbleibende Querblende hält den Rahmen zusammen. Die beiden Querblenden an einer Seite des Sockels lassen sich auch um 90° verdreht und horizontal ausgerichtet mit den Eckstücken verbinden, um einen schlitzförmigen Übergang zu schaffen. Dabei können die so verdreht eingebauten Querblenden auch noch mit den zugekehrten Eckstücken des in der Schaltschrankreihe benachbarten Schaltschrankes verbunden werden.

Da über die vordere Längsblende keine Kabeleinführung erfolgt, sieht eine weitere Ausgestaltung vor; daß vier Eckstücke die doppelte Höhe aufweisen wie vier Querblenden und zwei Längsblenden, jedoch die gleiche Höhe wie eine Längsblende und mit diesen zu einem Rahmen zusammengesetzt sind. Die Längsblende, die die gleiche Höhe aufweist wie die Eckstücke, bildet dann die Vorderseite des Sockels.

Die Eckstücke und die Blenden können auch als Bausatz bereitgestellt werden, der unterschiedliche Sockelhöhen zuläßt und an die Erfordernisse eines Überganges im Bereich der Querseiten des Sockels angepaßt werden kann, wenn dieser Eckstücke mit einer Grundhöhe und der doppelten Grundhöhe, Querblenden mit der Grundhöhe und Längsblenden mit der Grundhöhe und der doppelten Grundhöhe umfaßt.

Da es Schaltschränke unterschiedlicher Breite, jedoch gleicher Tiefe gibt, sieht eine weitere Ausgestaltung vor, daß die Längsblenden mit abgestuften Längen vorgesehen sind, die mit den Eckstücken auf vorgegebene Schrankbreiten abgestimmt sind.

Nach einer Ausgestaltung ist vorgesehen, daß an den Unter- und Oberkanten einer der Außenwände direkt die Schrank-Befestigungsflansche mit den Schrank-Befestigungsbohrungen nach innen abgebogen sind und daß die Schrank-Befestigungsflansche an ihren freien Kanten mittels gegeneinander gerichteter Abkantungen versteift sind, um die Eckstücke als einfache, einstückige Teile identisch herstellen zu können.

Damit die Blenden eine ausreichende Verwindungssteifigkeit bekommen, sieht eine weitere Ausgestaltung vor, daß die Längsseitenwände der Querblenden und der Längsblenden an ihren freien Kanten mittels gegeneinander gerichteter Abkantungen versteift sind.

Ist nach einer Ausgestaltung vorgesehen, daß zumindest eine Längsseitenwand der Querblenden mit Bohrungen versehen ist, dann können an den Querblenden mittels Halter zusätzliche Schienen, Kabelabfangschienen und dgl. angebracht werden.

Um einen möglichst großen Innenraum im Sockel zu erhalten, sieht eine weitere Ausgestaltung vor, daß die Höhe der Seitenwände der boxartigen Querblenden und der boxartigen Längsblenden der Breite der zugeordneten Blenden-Befestigungsflansche der Eckstücke entspricht.

Ist nach einer weiteren Ausgestaltung vorgesehen, daß die Querblenden mit Hilfe von mit Gewindebohrungen versehenen Befestigungsplatten an den zugeordneten Blenden-Befestigungsflanschen der Eckstücke befestigt sind und daß die Befestigungsplatten mit einer Abkantung jeweils den zugekehrten Blenden-Befestigungsflansch und die zugekehrte Querseitenwand der Querblende übergreifen und gegen Verdrehen sichern, dann lassen sich auch die Querblenden jeweils mit einer einzigen Schraubverbindung an den Eckstücken verdrehsicher befestigen.

Damit im Bereich der Querseiten des Sockels ein möglichst großer Übergang beim Abnehmen der Querblende bzw. der Querblenden geschaffen wird, ist die Ausgestaltung so, daß die an die Längsblenden anschließenden Außenwände der Eckstücke breiter sind als die an die Querblenden anschließenden Außenwände der Eckstücke. Eine ausreichende Befestigungsmöglichkeit für den Schaltschrank an den Eckstücken ergibt sich dabei dadurch, daß die Schrank-Befestigungsflansche an der breiteren Außenwand des Eckstückes abgebogen sind und daß die schmälere Außenwand mittels nach innen gerichteter Abkantungen versteift ist, wobei die einander zugekehrten Kanten der Schrank-Befestigungsflansche und der Abkantungen abgeschrägt sind und sich zu einer rechteckförmigen Tragfläche ergänzen. Gleichzeitig wird dadurch auch die schmälere Außenfläche des Eckstückes versteift.

Die Eckstücke, die Querblenden und die Längsblenden sind vorzugsweise als Stanz-Biege-Teile aus Metall ausgebildet und hergestellt.

Die Erfindung wird anhand eines in den Zeichnungen dargestellten Ausführungsbeispiels näher erläutert. Es zeigt:

Fig. 1   in Explosionsdarstellung einen aus vier Eckstücken, vier Querblenden und drei Längsblenden zusammengesetzten rahmenartigen Sockel,

Fig. 2   in perspektivischer Seitenansicht ein Eckstück des Sockels nach Fig. 1,

Fig. 3   in perspektivischer Ansicht die Verbindung einer Querblende mit dem Eckstück nach Fig. 2,

Fig. 4   in perspektivischer Ansicht die Verbindung von zwei Querblenden mit dem Eckstück nach Fig. 2, wobei die Querblenden als zusätzliche Befestigungsmöglichkeiten für Schienen, Kabelabfangschienen und dgl. ausgenützt sind und

Fig. 5   schematisch in perspektivischer Ansicht die Bildung eines Überganges zwischen benachbarten Schaltschränken im Bereich der einander zugekehrten Querseiten der beiden Sockel.

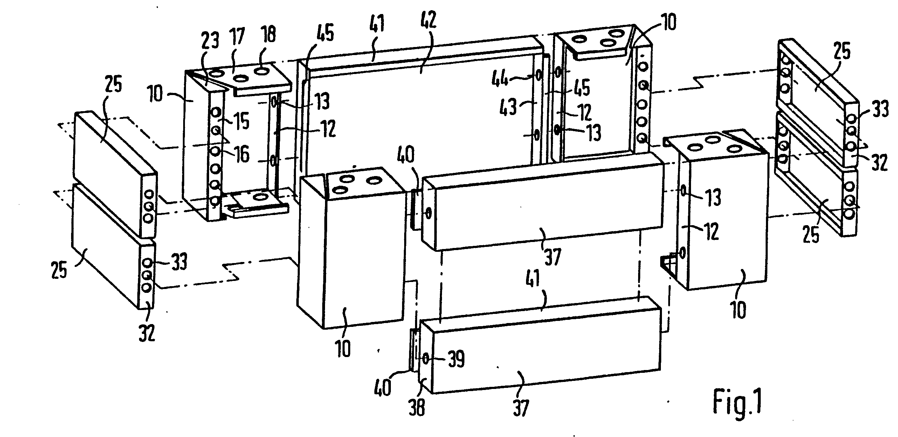

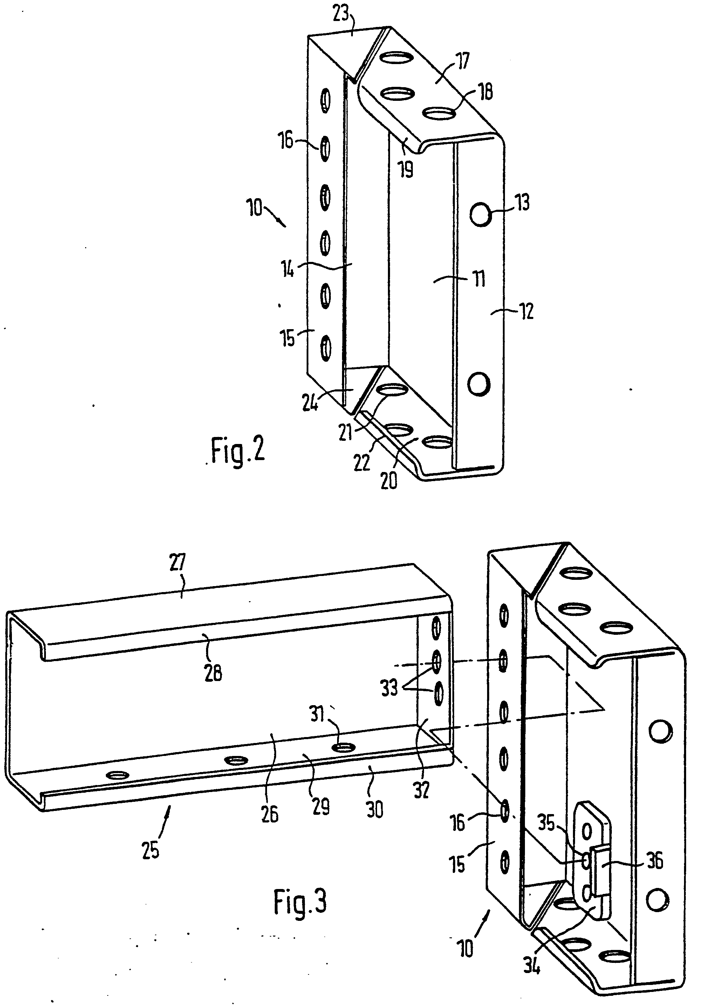

Die Explosionsdarstellung nach Fig. 1 zeigt die Teile, die zum Aufbau eines Sockels nach der Erfindung erforderlich sind. An den vier Ecken des rahmenartigen Sockels sind die vier identischen Eckstücke 10 angeordnet, die als einfache und einstückig hergestellte Stanz-Biege-Teile aus Metall bestehen. Die Eckstücke 10 weisen die beiden vertikalen Außenwände 11 und 14 auf, die im rechten Winkel zueinander stehen. Wie die perspektivische Ansicht nach Fig. 2 zeigt, ist die Außenwand 11 wesentlich breiter als die Außenwand 14. Die Anordnung der Eckstücke 10 im Sockel ist so, daß die breiteren Außenwände 11 auf die Längsseite des Sockels und die schmäleren Außenwände 14 auf die Querseiten des Sockels ausgerichtet sind, wie Fig. 1 erkennen läßt.

Die einander abgekehrten vertikalen Kanten der Außenwände 11 und 14 sind nach innen als Blenden-Befestigungsflansche 12 und 15 mit dem Raster an Blenden-Befestigungsbohrungen 13 und 16 abgebogen. Die Unter- und Oberkante der Außenwand 11 sind als Schrank-Befestigungsflansche 17 und 20 mit den Schrank-Befestigungsbohrungen 18 und 21 ebenfalls nach innen abgekantet. Die freien Kanten dieser Schrank-Befestigungsflansche 17 und 20 sind mit gegeneinander gerichteten Abkantungen 19 und 22 versteift. Im Eckbereich der beiden Außenwände 11 und 14 sind die Schrank-Befestigungsflansche 17 und 20 abgeschrägt, da auch die Unter- und Oberkante der schmäleren Außenwand 14 nach innen gerichtete Abkantungen 23 und 24 trägt, die sich mit den Schrank-Befestigungsflanschen 17 und 20 zu rechteckförmigen Tragflächen für den Schaltschrank ergänzen. Mit den oben gelegenen Schrank-Befestigungsflanschen 17 der vier Eckstücke 10 wird vorzugsweise das Rahmengestell des Schaltschrankes verschraubt.

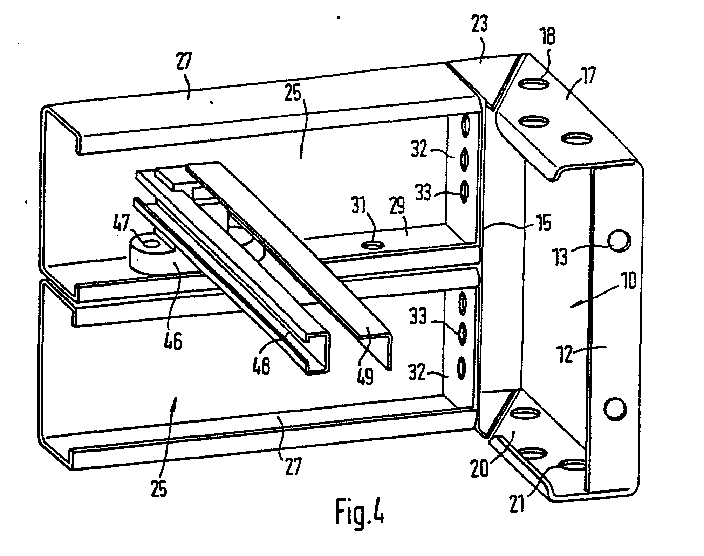

Die beiden Querseiten des Sockels werden jeweils durch zwei identische Querblenden 25 gebildet, die nur die halbe Höhe der Eckstücke 10 aufweisen. Wie aus Fig. 3 zu entnehmen ist, sind diese boxartigen Querblenden 25 ebenfalls als Stanz-Biege-Teil aus Metall hergestellt, wobei die Außenwand 26 mit den beiden Längsseitenwänden 27 und 29 und den Querseitenwänden 32 an den Querseiten der Querblende 25 versteift sind. Die Abkantungen 28 und 30 an den Längsseitenwänden 27 und 29 verbessern die Steifigkeit der Querblende 25 noch. Die Querseitenwände 32 tragen ein Raster von drei Befestigungsbohrungen 33, das auf das Raster der sechs Blenden-Befestigungsbohrungen 16 des Blenden-Befestigungsflansches 15 abgestimmt ist. Die Schraubverbindung umfaßt jeweils nur eine Befestigungsschraube, die durch eine Befestigungsbohrung 33 der Querseitenwand 32 der Querblende 25 und eine Blenden-Befestigungsbohrung 16 im Blenden-Befestigungsflansch 15 eingeführt und in eine Gewindebohrung 35 einer Befestigungsplatte 34 eingeschraubt wird. Diese Befestigungsplatte 34 legt sich auf der Innenseite des Blenden-Befestigungsflansches 15 an und übergreift mit einer Abkantung 36 die freien Kanten des Blenden-Befestigungsflansches 15 und der Querseitenwand 32 der Querblende 25, so daß die Querblende 25 trotz Verwendung von nur einer einzigen Befestigungsschraube dennoch verdrehsicher an den Eckstücken 10 gehalten ist. Dabei ist die Höhe der Querseitenwand 32 auf die Breite des Blenden-Befestigungsflansches 15 ausgelegt. Die Querseiten des Sockels werden durch zwei identische, übereinander gesetzte Querblenden 25 gebildet. Dabei können die Längsseitenwände 29 mit den Befestigüngsbohrungen 31 der beiden Querblenden 25 aufeinanderliegend angeordnet und mit den Eckstücken 10 verschraubt werden. Dies ergibt eine weitere Anbringungsmöglichkeit mit Hilfe von Haltern 46, die mit Befestigungsflanschen 47 versehen mit diesen Längsseitenwänden 29 verbunden werden können, wie Fig. 4 zeigt. An dem Halter 46 können DIN-Schienen 48, Kabelabfangschienen 49 und dgl. angebracht werden, die parallel zu den Längsseiten des Sockels verlaufen.

Die Längsseiten des Sockels werden einmal durch zwei boxartige Längsblenden 37 und zum anderen durch die boxartige Längsblende 42 gebildet. Die Längsseitenwände 41 dieser Längsblenden 37 und 42 sind ähnlich abgekantet und versteift wie die Längsseitenwände 27 und 29 der Querblenden 25. Die Querseitenwände 38 und 43 der Längsblenden 37 und 43 sind mit ihren Befestigungsbohrungen 39 und 44 auf das Raster der Befestigungsbohrungen 13 im Blenden-Befestigungsflansch 12 der Eckstücke 10 abgestimmt. Die Breite des Blenden-Befestigungsflansches 12 entspricht der Höhe der Querseitenwände 38 und 43 der Längsblenden 37 und 42. Die Querseitenwände 38 und 43 sind direkt mit den Blenden-Befestigungsflanschen 12 der zugeordneten Eckstücke 13 verschraubbar, wobei diese Schraubverbindungen vom Innenraum des Sockels her zugänglich sind. Wird die Bodenplatte des auf dem Sockel festgeschraubten Schaltschrankes entfernt, dann sind der Innenraum des Sockels und daher auch alle Befestigungsschrauben zugänglich, um einzelne Querblenden 25 oder Längsblenden 37 ud 42 von ihren zugeordneten Eckstücken 10 zu lösen.

Wie die Fig. 1 zeigt, sind die freien Kanten der Querseitenwände 38 und 43 der Längsblenden 37 und 42 mit nach außen gerichteten Abkantungen 40 und 45 versehen, die die freien Kanten der zugekehrten Blenden-Befestigungsflansche 12 übergreifen und trotz Verwendung von jeweils nur einer einzigen Schraubverbindung verdrehsicher an den Eckstücken 10 festhalten. Es genügt daher jeweils eine Befestigungsbohrung 39 an den Querseitenwänden 38 der Längsblenden 37, während die höhere Längsblende 42 an den Querseitenwänden 43 zwei Befestigungsbohrungen 44 aufweist.

Anhand der Fig. 1 läßt sich auch erläutern, wie ein Bausatz zur Erstellung von unterschiedlich hohen Sockeln beschaffen sein kann. Haben die Querblenden 25 und die Längsblenden 37 eine einheitliche Grundhöhe, dann läßt sich mit Eckstücken 10 derselben Grundhöhe ein Sockel aufbauen, wie er z. B. als normaler Standsockel für den Schaltschrank Verwendung finden kann. Werden jedoch Eckstücke 10 mit der doppelten Grundhöhe verwendet, dann bilden jeweils zwei Querblenden 25 mit der Grundhöhe eine Querseite des Sockels. Die Längsseiten des Sockels können durch zwei Längsblenden 37 mit der Grundhöhe oder einer Längsblende 42 mit der doppelten Grundhöhe gebildet werden. Da es Schaltschränke mit unterschiedlichen Schrankbreiten gibt, werden auch Längsblenden 37 und 42 mit Längen bereitgestellt, die unter Berücksichtigung der Breiten der Außenwände 11 der Eckstücke 10 auf diese Schrankbreiten abgestimmt sind.

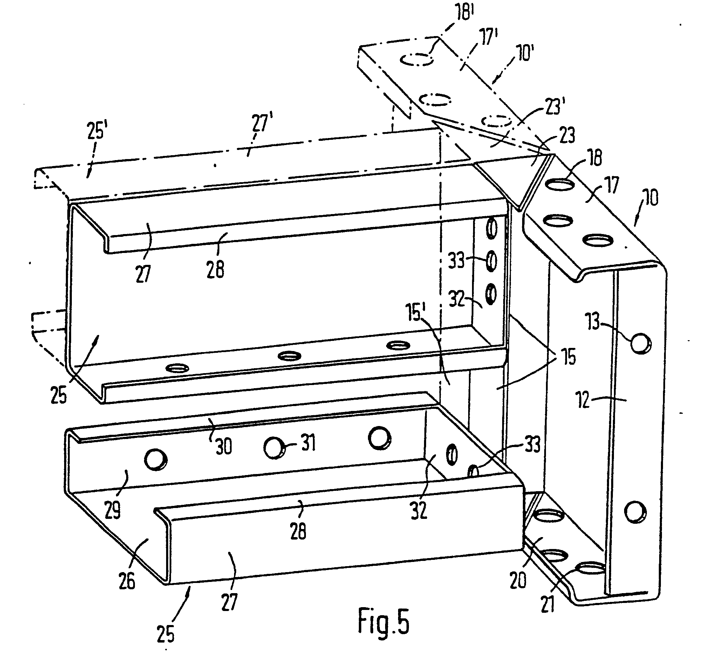

Wie Fig. 5 zeigt, kann bei einen Sockel mit zwei Querblenden 25 pro Querseite leicht ein Übergang zum benachbarten Schaltschrank geschaffen werden und zwar über dessen Sockel. Da die Schraubverbindungen über den Innenraum des Sockels leicht zugänglich ist, kann z. B. die untere Querblende 25 auch innerhalb einer Schaltschrankreihe gelöst und um 90° verdreht horizontal eingesetzt werden. Dabei kann die Außenwand 26 mit dem Schrank-Befestigungsflansch 20 der Eckstücke 10 die Standfläche des Sockels vergrößern. Wie das Eckstück 10' und die obere Querblende 25' des benachbarten Schaltschrankes erkennen lassen, verbleibt über der horizontal ausgerichteten Querblende 25 ein schlitzförmiger Übergang zwischen den beiden benachbarten Sockeln. Die Querseitenwände 32 dieser liegenden Querblende 25 können mit den beiden zugekehrten Blenden-Befestigungsflanschen 15 und 15' der Eckstücke 10 und 10' verschraubt werden, um auch die benachbarten Sockel fest miteinander zu verbinden. An die Längsseitenwand 29 mit den Befestigungsbohrungen 31 der liegenden Querblende 25 können DIN-Schienen, Kabelabfangschienen, Kabeldurchführungen, Kabeldichtungen und dgl. befestigt werden. Ist der Übergang zu klein, dann können auch die oberen hochkant stehenden Querblenden 25 und 25' entfernt werden, ohne den Ort der mit den Sockeln verbundenen Schaltschränke zu verändern. Wie die Seitenwände 27' und der Schrank-Befestigungsflansch 17' mit den Schrank-Befestigungsbohrunge 18' und der Abkantung 23' zeigen, hat der benachbarte Sockel dieselbe Tragfläche und Befestigungsmöglichkeit.

In gleicher Weise ist auch eine der Längsblenden 37 von ihren zugeordnetne Eckstücken 10 zu lösen, wenn z. B. an dieser Längsseite des Sockels, die der Rückseite des Schaltschrankes zugeordnet ist, Kabel eingeführt werden müssen. Die Längsblende 37 ist in den Innenraum des Sockels hinein abnehmbar und entfernbar. Die über die gesamte Höhe des Sockels reichende Längsblende 42 ist der Vorderseite des Schaltschrankes zugekehrt, da an dieser Längsseite keine Kabel eingeführt werden. Es lassen sich jedoch auf dieser Längsseite des Sockels auch zwei Längsblenden 37 verwenden. Anstelle der Eckstücke 10 mit doppelter Grundhöhe lassen sich auch zwei Eckstücke 10 mit der Grundhöhe übereinander anordnen und miteinander verschrauben. In jedem Fall bleiben aber sämtliche Schraubverbindungen des zusammengesetzten Sockels vom Innenraum desselben her zugänglich und jede Blende kann vom Innenraum des Sockels her gelöst und aus dem Sockel entfernt werden.

**Patentansprüche**

1. Sockel für einen Schaltschrank, der aus vier Eckstücken, mindestens zwei Querblenden und mindestens zwei Längsblenden zu einem Rahmen zusammengesetzt ist, bei dem die Eckstücke zwei im rechten Winkel zueinander stehende vertikale Außenwände, sowie unten und oben horizontale, mit Schrank-Befestigungsbohrungen versehene Schrank-Befestigungsflansche aufweisen und bei dem die Querblenden und die Längsblenden so mit den Eckstücken verschraubbar sind, daß sie bündig an die Außenflächen der Eckstücke anschließen, dadurch gekennzeichnet, daß die winkelförmig ausgebildeten Eckstücke (10) an den einander abgekehrten, vertikalen Kanten der Außenwände (11, 14) in rechtwinklig nach innen gebogene und mit einem Raster von Blenden-Befestigungsbohrungen (13, 16) versehene Blenden-Befestigungsflansche (12, 15) übergehen und daß die Querblenden (25) und die Längsblenden (37, 42) boxartig ausgebildet sind, wobei die den Blenden-Befestigungsflanschen (12, 15) der Eckstücke (10) zugekehrten Querseitenwände (32, 38, 43) der Querblenden (25) und der Längsblenden (37, 42) mit einem entsprechenden Raster von Befestigungsbohrungen (33, 39, 44) versehen sind.

2. Sockel nach Anspruch 1, dadurch gekennzeichnet, daß die Querseitenwände (38, 43) der Längsblenden (37, 42) an ihren freien Kanten nach außen gerichtete Abkantungen (40, 45) aufweisen, die die zugekehrten Blenden-Befestigungsflansche (15) der Eckstücke (10) übergreifen und die Längsblenden (37, 42) gegen Verdrehen sichern.

3. Sockel nach Anspruch 1, dadurch gekennzeichnet, daß vier Eckstücke, zwei Querblenden (25) und zwei Längsblenden (37) gleiche Höhe aufweisen und zu einem Rahmen zusammengesetzt sind.

4. Sockel nach Anspruch 1, dadurch gekennzeichnet, daß vier Eckstücke (10) die doppelte Höhe aufweisen, wie vier Querblenden (25) und vier Längsblenden (37) und mit diesen zu einem Rahmen zusammengesetzt sind.

5. Sockel nach Anspruch 1, dadurch gekennzeichnet, daß vier Eckstücke (10) die doppelte Höhe aufweisen wie vier Querblenden (25) und zwei Längsblenden (37), jedoch die gleiche Höhe wie eine Längsblende (42) und mit diesen zu einem Rahmen zusammengesetzt sind.

6. Sockel nach einem der Ansprüche 1 bis 5, dadurch gekennzeichnet, daß ein Bausatz Eckstücke (10) mit einer Grundhöhe und der doppelten Grundhöhe, Querblenden (25) mit der Grundhöhe und Längsblenden (37, 42) mit der Grundhöhe und der doppelten Grundhöhe umfaßt.

7. Sockel nach Anspruch 6,
dadurch gekennzeichnet,
daß die Längsblenden (37, 42) mit abgestuften Längen vorgesehen sind, die mit den Eckstücken (10) auf vorgegebene Schrankbreiten abgestimmt sind.

8. Sockel nach einem der Ansprüche 1 bis 7,
dadurch gekennzeichnet,
daß an den Unter- und Oberkanten einer der Außenwände (11, 14) direkt die Schrank-Befestigungsflansche (17, 20) mit den Schrank-Befestigungsbohrungen (18, 21) nach innen abgebogen sind und
daß die Schrank-Befestigungsflansche (17, 20) an ihren freien Kanten mittels gegeneinander gerichteten Abkantungen (19, 22) versteift sind.

9. Sockel nach einem der Ansprüche 1 bis 8,
dadurch gekennzeichnet,
daß die Längsseitenwände (27, 29, 41) der Querblenden (25) und der Längsblenden (37, 42) an ihren freien Kanten mittels gegeneinander gerichteten Abkantungen (28, 30) versteift sind.

10. Sockel nach einem der Ansprüche 1 bis 9,
dadurch gekennzeichnet,
daß zumindest eine Längsseitenwand (29) der Querblenden (25) mit Bohrungen (31) versehen ist.

11. Sockel nach einem der Ansprüche 1 bis 10,
dadurch gekennzeichnet,
daß die Höhe der Seitenwände (27, 29, 41) der boxartigen Querblenden (25) und der boxartigen Längsblenden (37, 42) der Breite der zugeordneten Blenden-Befestigungsflansche (12, 15) der Eckstücke (10) entspricht.

12. Sockel nach einem der Ansprüche 1 bis 11,
dadurch gekennzeichnet,
daß die Querblenden (25) mit Hilfe von mit Gewindebohrungen (35) versehenen Befestigungsplatten (34) an den zugeordneten Blenden-Befestigungsflanschen (15) der Eckstücke (10) befestigt sind und
daß die Befestigungsplatten (34) mit einer Abkantung (35) jeweils den zugekehrten Blenden-Befestigungsflansch (15) und die zugekehrte Querseitenwand (32) der Querblende (25) übergreifen und gegen Verdrehen sichern.

13. Sockel nach einem der Ansprüche 1 bis 12,
dadurch gekennzeichnet,
daß die an die Längsblenden (37, 42) anschließenden Außenwände (11) der Eckstücke (10) breiter sind als die an die Querblenden (25) anschließenden Außenwände (14) der Eckstücke (10).

14. Sockel nach Anspruch 13,
dadurch gekennzeichnet,
daß die Schrank-Befestigungsflansche (17, 20) an der breiteren Außenwand (11) des Eckstückes (10) abgebogen sind und
daß die schmälere Außenwand (14) mittels nach innen gerichteter Abkantungen (23, 24) versteift ist, wobei die einander zugekehrten Kanten der Schrank-Befestigungsflansche (17, 20) und der Abkantungen (23, 24) abgeschrägt sind und sich zu einer rechteckförmigen Tragfläche ergänzen.

15. Sockel nach einem der Ansprüche 1 bis 14,
dadurch gekennzeichnet,
daß die Eckstücke (10), die Querblenden (25) und die Längsblenden (37, 42) als Stanz-Biege-Teile aus Metall ausgebildet und hergestellt sind.

**Claims**

1. Base for a switchgear cabinet, which comprises four corner pieces, at least two transverse screens and at least two longitudinal screens to form a frame, wherein the corner pieces have two vertical outer walls, which extend at right angles to each other, and have at their lower and upper ends horizontal cabinet mounting flanges, which are provided with cabinet mounting bores, and wherein the transverse screens and the longitudinal screens are screw-connectable to the corner pieces in such a manner that they communicate with the outer faces of the corner pieces in a flush manner,
characterised in
that the angular corner pieces (10), at the vertical edges of the outer walls (11, 14) remote fromt one another, pass into screen mounting flanges (12, 15), which are bent inwardly at right angles and are provided with a grid of screen mounting bores (13, 16), and in
that the transverse screens (25) and the longitudinal screens (37, 42) are box-shaped, wherein the transverse side walls (32, 38, 43) of the transverse screens (25) and of the longitudinal screens (37, 42), facing the screen mounting flanges (12, 15) of the corner pieces (10), are provided with a corresponding grid of mounting bores (33, 39, 44).

2. Base according to claim 1,
characterised in
that the transverse side walls (38, 43) of the longitudinal screens (37, 42) have, at their free edges, outwardly directed bent-over portions (40, 45) which engange over the facing screen mounting flanges (15) of the corner pieces (10) and prevent the longitudinal screens (37, 42) from twisting.

3. Base according to claim 1,
characterised in
that four corner pieces, two transverse screens (25) and two lingitudinal screens (37) have the same height and are combined to form a frame.

4. Base according to claim 1,
characterised in
that four corner pieces (10) have a height corresponding to twice that of four transverse screens (25) and four longitudinal screens (37) and are combined therewith to form a frame.

5. Base according to claim 1,
characterised in
that four corner pieces (10) have a height corresponding to twice that of four transverse screens (25) and two longitudinal screens (37), but they have the same height as one longitudinal screen (42) and are combined therewith to form a frame.

6. Base according to any of claims 1 to 5, <u>characterised in</u> that one structural assembly includes corner pieces (10) having a basic height and twice the basic height, transverse screens (25) having the basic height, and longitudinal screens (37, 42) having the basic height and twice the basic height.

7. Base according to claim 6, <u>characterised in</u> that the longitudinal screens (37, 42) are provided with graduated lengths which are adapted, with the corner pieces (10), to prescribed cabinet widths.

8. Base according to any of claims 1 to 7, <u>characterised in</u> that the cabinet mounting flanges (17, 20), provided with the cabinet mounting bores (18, 21), are directly bent inwardly at the lower and upper edges of one of the outer walls (11, 14), and in that the cabinet mounting flanges (17, 20) are reinforced at their free edges by means of bent-over portions (19, 22) which are directed towards one another.

9. Base according to any of claims 1 to 8, <u>characterised in</u> that the longitudinal side walls (27, 29, 41) of the transverse screens (25) and of the longitudinal screens (37, 42) are reinforced at their free edges by means of bent-over portions (28, 30) which are directed towards one another.

10. Base according to any of claims 1 to 9, <u>characterised in</u> that at least one longitudinal side wall (29) of the transverse screens (25) is provided with bores (31).

11. Base according to any of claims 1 to 10, <u>characterised in</u> that the height of the side walls (27, 29, 41) of the box-shaped transverse screens (25) and of the box-shaped longitudinal screens (37, 42) corresponds to the width of the associated screen mounting flanges (12, 15) of the corner pieces (10).

12. Base according to any of claims 1 to 11, <u>characterised in</u> that the transverse screens (25) are mounted on the associated screen mounting flanges (15) of the corner pieces (10) by means of mounting plates (34), which are provided with threaded bores (35), and in that the each of the mounting plates (34), provided with a bent-over portion (35), engages over the facing screen mounting flange (15) and over the facing transverse side wall (32) of the transverse screen (25) and prevents twisting.

13. Base according to any of claims 1 to 12, <u>characterised in</u> that the outer walls (11) of the corner pieces (10), which communicate with the longitudinal screens (37, 42), are wider than the outer walls (14) of the corner pieces (10), which communicate with the transverse screen (25).

14. Base according to claim 13, <u>characterised in</u> that the cabinet mounting flanges (17, 20) are bent at the wider outer wall (11) of the corner piece (10), and in that the narrower outer wall (14) is reinforced by means of inwardly directed bent-over portions (23, 24), wherein the edges of the cabinet mounting flanges (17, 20) and of the bent-over portions (23, 24), which face one another, are inclined and combine to form a rectangular supporting face.

15. Base according to any of claim 1 to 14, <u>characterised in</u> that the corner pieces (10), the transverse screens (25) and the longitudinal screens (37, 42) are stamped and bent component parts and are formed from metal.

**Revendications**

1. Socle pour armoire de branchements, composé de quatre pièces d'angle, d'au moins deux cadres transversaux et d'au moins deux cadres longitudinaux pour former un cadre, dans lequel les pièces d'angle présentent deux parois extérieures verticales formant entre elles un angle droit, ainsi que des embases pour fixation d'armoires horizontales au-dessus et au dessous, comportant des alésages pour fixation d'armoire et dans lequel les cadres transversaux et les cadres longitudinaux peuvent être vissés aux pièces d'angles de telle façon qu'ils affleurent les surfaces extérieures des pièces d'angles, socle <u>caractérisé en ce</u> que les pièces d'angle (10) en forme d'équerre se transforment sur les bords verticaux opposés des parois extérieures (11, 14), pour former des embases (12, 15) pour fixation de cadres, repliées à angle droit vers l'intérieur et munies d'un réseau d'alésages (13, 16) pour fixation de cadres et en ce que les cadres transversaux (25) et les cadres longitudinaux (37, 42) ont une forme de boîte, les parois latérales transversales (32, 38, 43) des cadres transversaux (25) et des cadres longitudinaux (37, 42) tournées vers les embases (12, 15) de fixation de cadres des pièces d'angle (10) étant munies d'un réseau correspondant d'alésages (33, 39, 44) pour la fixation.

2. Socle selon la revendication 1, <u>caractérisé en ce</u> que les parois latérales transversales (38, 43) des cadres longitudinaux (37, 42) présentent sur leurs arêtes libres des replis (40, 45) orientés vers l'extérieur qui entourent les embases de fixation de cadres dirigées vers elles, et empêchent les cadres longitudinaux (37, 42) de tourner.

3. Socle selon la revendication 1, <u>caractérisé en ce</u> que quatre pièces d'angle, deux cadres transversaux (25) et deux cadres longitudinaux (37) présentent la même hauteur et sont assemblés pour former un cadre.

4. Socle selon la revendication 1,
caractérisé en ce
quatre pièces d'angle (10) présentent une hauteur double de celle de quatre cadres transversaux (25) et de quatre cadres longitudinaux (37) et sont assemblés avec ces derniers pour former un cadre.

5. Socle selon la revendication 1,
caractérisé en ce
que quatre pièces d'angle (10), présentant la hauteur double de celle de quatre cadres transversaux (25) et de deux cadres longitudinaux (37), mais cependant la même hauteur qu'un cadre longitudinal (42), sont assemblées avec ceux-ci pour former un cadre.

6. Socle selon une des revendications 1 à 5,
caractérisé en ce qu'un jeu de pièces de construction comprend des pièces d'angle (10) ayant une hauteur de base et ayant une hauteur double de la hauteur de base, des cadres transversaux (25) ayant la hauteur de base et des cadres longitudinaux (37, 42) ayant la hauteur de la base et ayant une hauteur double de la hauteur de base.

7. Socle selon la revendication 6,
caractérisé en ce
que les cadres longitudinaux (37, 42) sont prévus avec des longueurs étagées qui concordent ainsi que les pièces d'angles (10) avec les largeurs prévues pour les armoires.

8. Socle selon une des revendications 1 à 7,
caractérisé en ce
que sur les arêtes inférieures et supérieures d'une des parois extérieures (11, 14) sont directement repliées vers l'intérieur des embases (17, 20) pour fixation d'armoires comportant des alésages (18, 21) pour fixation d'armoires et en ce que les embases (17, 20) pour fixation d'armoires sont raidies sur leurs arêtes libres au moyen de replis (19, 22) dirigés les une vers les autres.

9. Socle selon une des revendications 1 à 8,
caractérisé en ce
que les parois latérales longitudinales (27, 29, 41) des cadres transversaux (25) et des cadres longitudinaux (37, 42) sont raidies à leurs arêtes libres au moyen de replis (28, 30) dirigés les une vers les autres.

10. Socle selon une des revendications 1 à 9,
caractérisé en ce
qu'au moins une paroi latérale longitudinale (29) des cadres transversaux (25) est munie d'alésages (31).

11. Socle selon une des revendications 1 à 10,
caractérisé en ce
que la hauteur des parois latérales (27, 29, 41) des cadres transversaux (25) en forme de boîtes et des cadres longitudinaux (37, 42) en forme de boîtes, correspond à la largeur des embases (12, 15), associées pour fixation de cadre des pièces d'angle (10).

12. Socle selon une des revendications 1 à 11,
caractérisé en ce,
que les cadres transversaux (25) sont fixés à l'aide de plaques (34) de fixation munies de trous taraudés (35), aux embases (15) associées pour fixation de cadres des pièces d'angle (19) et en ce que les plaques (34) de fixation entourent dans chaque cas avec un repli (35) l'embase (15) pour fixation de cadre dirigée vers elles, et la paroi latérale transversale (32) du cadre transversal (25) dirigée vers elles et les empêchent de tourner.

13. Socle selon une des revendications 1 à 12,
caractérisé en ce,
que les parois latérales extérieures (11) des pièces d'angle (10), parois qui se raccordent aux cadres longitudinaux (37, 42), sont plus larges que les parois latérales extérieures (14) des pièces d'angle (10) qui se raccordent aux cadres transversaux (25).

14. Socle selon la revendication 14,
caractérisé en ce,
que les embases (17, 20) pour fixation d'armoire sont repliées contre la paroi extérieure (11) plus large de la pièce d'angle (10) et en ce que la paroi extérieure (14) plus étroite est raidie au moyen de replis (23, 24) dirigés vers l'intérieur, les arêtes dirigées les unes vers les autres des embases (17, 20) pour fixation d'armoire et les arêtes des replis (23, 24) état chanfreinées et se complétant pour former une surface porteuse rectangulaire.

15. Socle selon une des revendications 1 à 14,
caractérisé en ce
que la pièce d'angle (10), les cadres transversaux (25) et les cadres longitudinaux (37, 42) sont constitués et fabriqués en tant que pièces métalliques découpées et emboutées ou pliées.

Fig.1

Fig.2

Fig.3

3

Fig.4

Fig.5